Europäisches Patentamt

European Patent Office

Office européen des brevets

(19)

(11) **EP 1 252 646 B1**

(12) **EUROPÄISCHE PATENTSCHRIFT**

(45) Veröffentlichungstag und Bekanntmachung des Hinweises auf die Patenterteilung:
**26.10.2005 Patentblatt 2005/43**

(21) Anmeldenummer: **00991544.8**

(22) Anmeldetag: **20.12.2000**

(51) Int Cl.$^7$: **H01J 37/153**

(86) Internationale Anmeldenummer:
**PCT/DE2000/004578**

(87) Internationale Veröffentlichungsnummer:
**WO 2001/056057 (02.08.2001 Gazette 2001/31)**

(54) **VERFAHREN ZUR ERMITTLUNG GEOMETRISCH OPTISCHER ABBILDUNGSFEHLER**

METHOD FOR DETECTING GEOMETRICAL-OPTICAL ABERRATIONS

PROCEDE DE DETECTION D'ERREUR DE REPRESENTATION OPTIQUE GEOMETRIQUE

(84) Benannte Vertragsstaaten:
**DE FR GB NL**

(30) Priorität: **26.01.2000 DE 10003127**

(43) Veröffentlichungstag der Anmeldung:
**30.10.2002 Patentblatt 2002/44**

(73) Patentinhaber:
• **Ceos Corrected Electron Optical Systems GmbH**
**69125 Heidelberg (DE)**
• **JEOL Ltd.**
**Akishima, Tokyo 196 (JP)**

(72) Erfinder: **ZACH, Joachim**
**76684 Östringen (DE)**

(74) Vertreter: **Pöhner, Wilfried Anton, Dr. et al**
**Postfach 63 23**
**97013 Würzburg (DE)**

(56) Entgegenhaltungen:
**DE-A- 19 739 290        GB-A- 2 305 324**

• **OGASAWARA M ET AL: "Automatic focusing and astigmatism correction method based on Fourier transform of scanning electron microscope images" JAPANESE JOURNAL OF APPLIED PHYSICS, PART 1 (REGULAR PAPERS, SHORT NOTES & REVIEW PAPERS), FEB. 1999, PUBLICATION OFFICE, JAPANESE JOURNAL APPL. PHYS, JAPAN, Bd. 38, Nr. 2A, Seiten 957-960, XP002167741 ISSN: 0021-4922**
• **ZACH J ET AL: "Aberration correction in a low voltage SEM by a multipole corrector" NUCLEAR INSTRUMENTS & METHODS IN PHYSICS RESEARCH, SECTION - A: ACCELERATORS, SPECTROMETERS, DETECTORS AND ASSOCIATED EQUIPMENT,NL,NORTH-HOLLAND PUBLISHING COMPANY. AMSTERDAM, Bd. A363, Nr. 1, 1995, Seiten 316-325, XP004009662 ISSN: 0168-9002**

## Beschreibung

Die Erfindung bezieht sich auf ein Verfahren zur Ermittlung geometrisch optischer Abbildungsfehler bis einschließlich 3. Ordnung in teilchenoptischen, sondenformenden Anordnungen, insbesondere Rasterelektronenmikroskopen, mit einer im wesentlichen punktförmigen Quelle, die die Teilchen emittiert, Linsen zur Beeinflussung des Teilchenstrahls, einem Objekt, das durch die Teilchen abgebildet wird, und einem Detektor zur Registrierung der Teilchen bzw. der Abbildung des Objekts, wobei das Objekt mit einem auf das Objekt fokussierten Teilchenstrahl abgebildet und die Abbildung erfaßt wird, der Vorgang mit einem unter- und einem überfokussierten Strahl wiederholt wird, welche die Abbildungen (überfokussiert) und (unterfokussiert) ergeben, die Abbildungen in den Fourierraum transformiert werden, die Transformation der überfokussierten Abbildung durch die der transformierten fokussierten Abbidlung dividiert und der Quotient erhalten wird, und die Transformation der unterfokussierten Abbildung durch die der transformierten fokussierten Abbildung dividiert und der Quotient erhalten wird.

Das Wirkungsprinzip von Rasterelektronenmikroskopen beruht darauf, daß ein scharf gebündelter Elektronenstrahl, dessen Durchmesser die Leistungsfähigkeit und Auflösung bestimmt, zeilenweise über eine zu untersuchende Objektoberfläche geführt wird. Die durch das Objekt hindurchtretenden oder von ihm zurückgestreuten Elektronen bzw. in dessen Oberfläche ausgelöste Sekundärelektronen werden entweder in einem Kollektor gesammelt oder mit Hilfe eines Szintillators und eines nachgeschalteten Fotomultipliers verstärkt und zur Steuerung der Anzeige genutzt. Zur Emission der Elektronen wird eine unter Hochspannung stehende Quelle verwendet, die meist in Form einer Wolframspitze ausgeführt ist, deren Durchmesser im Bereich weniger nm liegt. Mit ihr ist eine im wesentlichen punktförmige Teilchenquelle praktisch beliebig genau realisierbar. Die Abbildung der Quelle, d.h. der Wolframspitze, durch die Optik des Mikroskops wird in der Regel als Sonde bezeichnet.

Bei teilchenoptischen Anordnungen, insbesondere Rasterelektronenmikroskopen, ist das Auflösungsvermögen sowie die Güte der Abbildung u.a. durch die geometrisch optischen Abbildungsfehler begrenzt,die zur Folge haben, daß punktförmige Objekte in der Abbildung nicht ideal punktförmig wiedergegeben werden. In der Nähe des theoretischen Bildpunktes entsteht als Einhüllende der sich in seiner Nähe tatsächlich schneidenden Strahlen die Kaustik. Bekannt ist der rotationssymmetrische Öffnungsfehler (sphärische Aberration) bei dem sich die achsenparallel einfallenden Strahlen im Bildraum vor dem durch die paraxialen Strahlen gelieferten Bildpunkt bzw. dahinter schneiden. Die axialen Bildfehler höherer Zähligkeit führen zu Vergrößerungen des Bildpunktes, die in Abhängigkeit vom Azimut unterschiedlich ausfällt. Beim zweizähligen Astigmatismus wird ein kreisförmiges Objekt in der Bildebene zu einer elliptischen Abbildung verzerrt, da die meridionalen und die dazu senkrechten sagittalen Strahlen unterschiedliche Brennweiten haben. Zur Korrektur dieser bis zur 3. Ordnung reichenden axialen Abbildungsfehler ist der Einsatz von aus unrunden Linsensystemen bestehenden Korrektiven bekannt, sowie beispielsweise aus der PCT/DE98/02596 ein Verfahren zur Beseitigung sämtlicher axialer Bildfehler bis zur 3. Ordnung, um das Auflösungsvermögen zu erhöhen.

Aus dem Beitrag aus Japanese Journal, Appl. Phys., Band 38 (1999) Seiten 957 ff. und der GB 2 305 324 A sind Verfahren zur Ermittlung der Bildfehler 1. Ordnung bekannt, bei denen die Bilder von zwei unterschiedlichen Fokussierungen in den Fourierraum transformiert werden und durch Quotientenbildung zur Ermittlung der Bildfehlerkoffizienter genutzt werden. Dieses geschilderte Verfahren ist ungeeignet zur Ermittlung der Bildfehler höherer Ordnung.

Als nachteilig hierbei ist anzusehen, daß die im Bildpunkt erhaltenen Informationen sowohl bestimmt werden durch die optischen Bildfehler des abbildenden sondenformenden optischen Systems als auch durch die Objektstruktur selbst. Zur Bestimmung der Bildfehler wäre es deshalb notwendig, die Objektstruktur zu kennen, um aus der erhaltenen Abbildung und der bekannten Objektstruktur Rückschlüsse auf Art und Größe des Abbildungsfehlers ziehen zu können.

Ausgehend vom Stand der Technik hat sich die Erfindung zur Aufgabe gestellt, ein Verfahren anzugeben, mit dem die geometrisch optischen Abbildungsfehler ermittelt werden können, ohne die Objektstruktur, die durch den von der Quelle emittierten Teilchenstrahl abgebildet wird, genau zu kennen.

Erfindungsgemäß wir diese Aufgabe dadurch gelöst, daß beide Quotienten zurücktransformiert werden und damit die Helligkeitsprofile der Sonden, d.h. der Abbildungen der Quelle im Über- und Unterfokus, ermittelt werden, die Asymmetrie (AS) der Profile bezüglich des Schwerpunktes, die Breite (BR) der Profile, insbesondere die Halbwertsbreite, und/oder die Krümmung (KR) der Profile im Schwerpunkt bestimmt wird, aus den Unterschieden der Profile der Sonden hinsichtlich dieser Größen die Abbildungsfehler ermittelt werden.

Die Grunderkenntnis der Erfindung besteht darin, daß bei einer Transformation der Abbildungen des Objekts mit einem auf das Objekt fokussierten und einem über- bzw. unterfokussierten Teilchenstrahl sowie einer anschließenden Division der Transformierten im Fourierraum die Objektstruktur aus dem erhaltenen Quotienten herausdividiert wird. Die Abbildung entspricht mathematisch einer Faltung des Objekts mit einer fokussierten oder defokussierten Sonde, also im Fourierraum einem Produkt aus Objekt- und Sondeninformation. Demzufolge kann nach der Fouriertransformation die Objektinformation durch eine Division der beiden Transformierten eliminiert werden. Das bedeutet, daß durch die Division im Fourierraum die in den Transformationen der Abbildungen enthaltenen Informationen des abzubildenden Objekts eliminiert werden, sodaß die Informationen über die optischen Bildfehler verbleiben. Hierbei ist gemäß üblicher Terminologie unter dem Begriff unter- bzw. überfokussiert zu verstehen, daß der Teilchenstrahl nicht in der Ebene des Objekts gebündelt ist, sondern bezüglich der optischen Achse davor oder dahinter. Ist der Defokus groß gegen den Sondendurchmesser bei einer Abbildung mit einem fokussierten Teilchenstrahl, ist das fokussierte Bild eine näherungsweise ausreichende Wiedergabe der Objektstruktur. Die hierzu notwendige Bedingung einer im wesentlichen punktförmigen Quelle wird druch die oben beschriebene Wolframspitze hinreichend erfüllt. In diesem Fall kann die defokussierte Sonde, d. h. eine Abbildung der Quelle mit einem defokussierten Teilchenstrahl, aus der Rücktransformation des Quotienten, der keine Informationen mehr über die Objektstruktur enthält, erhalten werden. Nach dieser Rücktransformation können die geometrisch optischen Abbildungsfehler ermittelt werden, die zur Verzerrung der Sondenprofile führen. Dazu werden durch die Sonderprofile Schnitte gelegt, um den Verlauf von Intensität bzw. Helligkeit der Abbildungen im Profil, d. h. senkrecht zur optischen Achse, zu ermitteln. Die Schnitte werden, wie weiter unten ausgeführt, in äquidistanten Winkelintervallen angelegt, um auch die Helligkeits- bzw. Intensitätsverteilung der Abbildung um die optische Achse zu bestimmen. Zur Ermittlung der geometrisch optischen Bildfehler werden die Asymmetrie der Profile bezüglich des Schwerpunktes bestimmt, in dem die Meßwerte des Schnitts links und rechts vom Schwerpunkt voneinander subtrahiert werden, die Breite des Schnitts, wobei hier zur Vereinfachung der Auswertung zumeist die Halbwertsbreite gewählt wird, und/oder dessen Krümmung im Schwerpunkt. Aus diesen zumeist unterschiedlichen Werten für die über- und unterfokussierten Sonden können auch noch Mittelwerte und/oder Differenzen gebildet werden. Aus diesen winkelabhängigen Werten kann der Fachmann die Bildfehler ermitteln und daraus durch Einstellen eines Korrektivs oder mit Hilfe mathematischer Bildrekonstruktionsverfahren die Korrektur vornehmen, um eine scharfe, nicht verzerrte Abbildung zu erhalten.

Der Vorteil der Erfindung besteht darin, daß lediglich ein Objekt mehrmals abgebildet werden muß, um aus den fokussierten, über- und unterfokussierten Abbildungen die geometrischen Abbildungsfehler zu ermitteln, ohne daß die tatsächliche Struktur des Objekts bekannt sein muß. Daraus können Korrekturgrößen ermittelt werden, mit denen bei späteren Meßreihen und anderen Objekten die erhaltenen Meßergebnisse, d.h. Abbildungen, korrigiert werden, um zu einer scharfen Abbildung zu gelangen. Hierzu wird die Optik der Anordnung auf analoge Weise durch Einstellung eines Korrektivs entsprechend justiert oder mathematische Korrekturverfahren angewandt, um die Fehler zu kompensieren.

Vorteilhafte Ausgestaltungen des Verfahrens sind Gegenstand von Unteransprüchen.

Zur Durchführung der Fouriertransformation bei einem auf das Objekt fokussierten oder defokussierten Teilchenstrahl wird vorgeschlagen, daß die Transformation mathematisch vorgenommen wird, insbesondere nach der dem Fachmann bekannten Fast-Fourier-Transformation. Prinzipiell ist es auch möglich, eine solche Transformation auf analoge Weise durch Herstellung eines Beugungsbilds vorzunehmen. Mit den selben Methoden können auch Rücktransformationen der jeweiligen Quotienten erfolgen.

Besonders bei Rasterelektronenmikroskopen bestehen die Linsen zur Beeinflussung der Richtung des Elektronenstrahls aus elektrischen und/oder magnetischen Multipolen, da mit ihnen in einfacher und dem Fachmann bekannter Weise der Elektronenstrahl gebündelt und abgelenkt werden kann. Bei dieser Art von Linsen ist auch eine Korrektur der geometrisch optischen Abbildungsfehler auf einfache Weise realisierbar, da hier die elektrischen und/oder magnetischen Felder mit einem nach dem oben beschriebenen Verfahren ermittelten Korrekturfaktor beaufschlagt d. h. verändert werden, um eine fehlerfreie Abbildung des Objekts zu erhalten.

Um sicher zu stellen, daß die Information der Objektstruktur durch die Division im Fourierraum tatsächlich eliminiert wird, muß die Breite der defokussierten Sonde, d.h. der Abbildung der Quelle im defokussierten Zustand, mindestens zehn mal größer sein, als die Breite der fokussierten Sonde bzw. der tatsächlichen Breite der Teilchenquelle.

Vorteilhafterweise werden die Schnitte durch die Sondenprofile in äquidistanten Winkelintervallen, insbesondere alle 15 Grad, gelegt, um eine hinreichende Auflösung der Helligkeits- bzw. Intensitätsprofile um die optische Achse zu erhalten. Zur Ermittlung der geometrisch optischen Abbildungsfehler werden die Zähligkeiten der Schnitte untersucht, d. h. wie viele Symmetrieebenen das Sondenprofil senkrecht zur optischen Achse aufweist.

Die Asymmetrie der Schnitte dienen der Ermittlung der Abbildungsfehler zweiter Ordnung. Da diese in Über- und Unterfokus theoretisch gleich sein sollten, kann aus beiden Messungen der Mittelwert zur weiteren Analyse gebildet werden, wobei dieser aus dem Über- und Unterfokus gebildete und vom Schnittwinkel w abhängige Mittelwert im Hinblick auf den Schnittwinkel einer Analyse auf die ein- und dreizähligen Winkelkomponenten, beispielsweise mit Hilfe einer Fourieranalyse, nach dem Schnittwinkel w unterzogen wird. Die einzählige Komponente stellt im Hinblick auf Orientierung und Größe den Wert der axialen Koma 2. Ordnung dar; die dreizählige Komponente der Analyse liefert nach Orientierung und Größe den Wert des dreizähligen Astigmatismus 2. Ordnung.

Die vom Schnittwinkel w abhängigen Breiten BR (w) und Krümmungen KR (w) der Sondenprofile können zur Bestimmung weiterer geometrisch optischer Bildfehler verwendet werden. Allgemein gesprochen ergibt die Breite BR der Sondenprofile eine Ermittlungsgrundlage für die Bildfehler 1. Ordnung und die ermittelten Werte der Krümmung KR die Werte der Abbildungsfehler 3. Ordnung. Zur Analyse ist jedoch folgende Vorgehensweise erforderlich: Gemeinsam ist, daß jeweils die Differenzen zwischen den Meßwerten bei Über- und Unterfokus in Abhängigkeit vom Schnittwinkel w ermittelt werden. Im fehlerfreien Fall würden die Differenzen verschwinden. Auch hier ist eine Analyse der erhaltenen Differenzwerte nach ihrer Zähligkeit über den Schnittwinkel w, beispielsweise mit Hilfe der Fourieranalyse, vorzunehmen. Man erhält auf diesem Wege die nach ihren Zähligkeiten geordneten Komponenten des Spektrums in Abhängigkeit vom Schnittwinkel w. Die entsprechende Zähligkeit erlaubt die Zuordnung zu den entsprechenden geometrisch optischen Bildfehlern; der betragsmäßige Wert und - abgesehen von dem rotationssymmetrischen Bildfehler - dessen Orientierung einen Rückschluß auf die Größe und ggf. Ausrichtung eines bestimmten Bildfehlers. Grundsätzlich gilt, daß die Breiten BR des Sondenprofiles bzw. den Differenzen im Über-/Unterfokus die Bildfehler 1. Ordnung, nämlich Defokussierung und zweizähliger Astigmatismus 1. Ordnung, zu ermitteln erlauben. Die nullzählige Komponente ermittelt über den Schnittwinkel der Differenz der Breite, also der über den Schnittwinkel w gebildete Mittelwert, der somit richtungsunabhängig ist, ergibt eine Maßzahl für die Fokussierung bzw. Defokussierung des elektronenoptischen Systems. Der nullzählige Bildfehler erster Ordnung stellt die Defokussierung dar.

Die durch die gleiche Fourieranalyse ermittelte zweizählige Komponente aus der Differenz der Breiten der Sondenprofile ergibt nach Größe und Orientierung den Wert des Fehlers des zweizähligen Astigmatismus 1. Ordnung.

Aus den Krümmungen der Sondenprofile KR (w) bzw. der aus Über- und Unterfokus gebildeten Differenzen lassen sich die einzelnen Fehlerkomponenten der Bildfehler 3. Ordnung ebenfalls durch eine Analyse der Zähligkeit über den Schnittwinkel, beispielsweise durchgeführt mit Hilfe einer Fourieranalyse, ermitteln. Auch hier sind in Abhängigkeit von der Zähligkeit bestimmte Bildfehler zugeordnet, wobei die Größe der Komponente den Betrag und die Orientierung des vorhandenen Bildfehlers wiedergeben. So ergibt die nullzählige Komponente, d. h. Mittelwert über den Schnittwinkel w eine Maßzahl für den Öffnungsfehler 3. Ordnung (sphärische Aberration) an. Die zweizählige Komponente gibt nach Betrag und Richtung die Maßzahl für den Sternfehler 3. Ordnung. Schließlich ergibt die vierzählige Komponente, ebenfalls nach Betrag und Richtung, den Wert für den vierzähligen Astigmatismus wieder. Damit sind sämtliche elektronenoptische Bildfehler 3. Ordnung ermittelt.

Da bei realen optischen Systemen die Abbildungsfehler 1. und 3. Ordnung niemals vollständig in Breite und Krümmung entkoppelt sind, kann eine genauere Ermittlung der Fehler 3. Ordnung dadurch erfolgen, daß anstatt der Krümmung (KR) oder der Breite (BR) bzw. der jeweiligen Differenzen Linearkombinationen beider Werte nach obigem Schema verwendet werden. Die jeweils zugehörigen Multiplikationsfaktoren $\alpha$ und $\beta$ nach der Formel:

$$\alpha * BR + \beta * KR$$

müssen für jede teilchenoptische Anordnung auf empirischem Wege ermittelt werden, um zum bestmöglichen Resultat zu gelangen. Für den Öffnungsfehler 3. Ordnung ist der Mittelwert über den Schnittwinkel w zu bilden.

Weitere Einzelheiten, Merkmale und Vorteile der Erfindung lassen sich dem nachfolgenden Beschreibungsteil entnehmen, in dem anhand mehrerer Zeichnungen Ausführungsbeispiele der Erfindung näher dargestellt sind. Es zeigen:

Figur 1    eine schematische Darstellung eines Rasterelektronenmikroskops,

Figur 2    ein Flußdiagramm zur Ermittlung der Sondenform,

Figur 3    Analyse eines Sondenprofils,

Figur 4+5    Schnitte durch ein Sondenprofil.

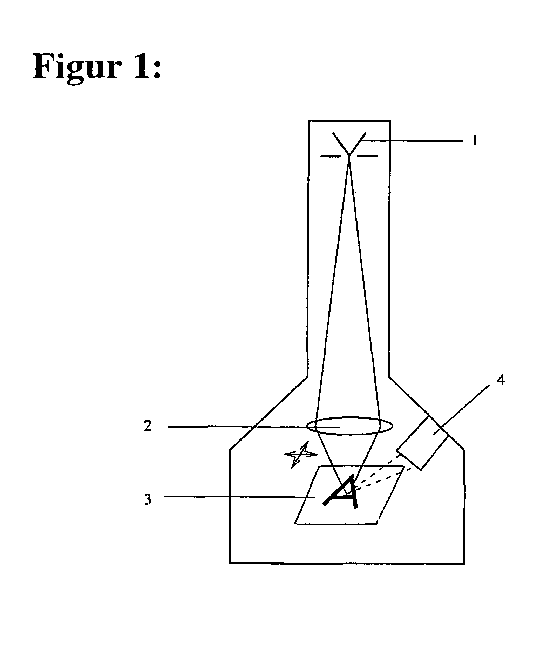

Bei dem in Figur 1 dargestellten Ausführungsbeispiel der Erfindung handelt es sich um ein Rasterelektronenmikroskop, bei dem von einer Quelle (1), zumeist einer annähernd punktförmigen Wolframspitze, Elektronen emittiert, und mit Linsen (2) wie beispielsweise elektrischen und/oder magnetischen Multipolen zeilenweise über das abzubildende Objekt (3) geführt werden, wie durch die Pfeile angedeutet. Die vom Objekt (3) zurückgestrahlten Elektronen, bzw. die von ihm emittierten Sekundärelektronen, werden mit Hilfe eines geeigneten Detektors (4) registriert, der eine Abbildung in Form einer Helligkeits- oder Intenstitätsverteilung registriert.

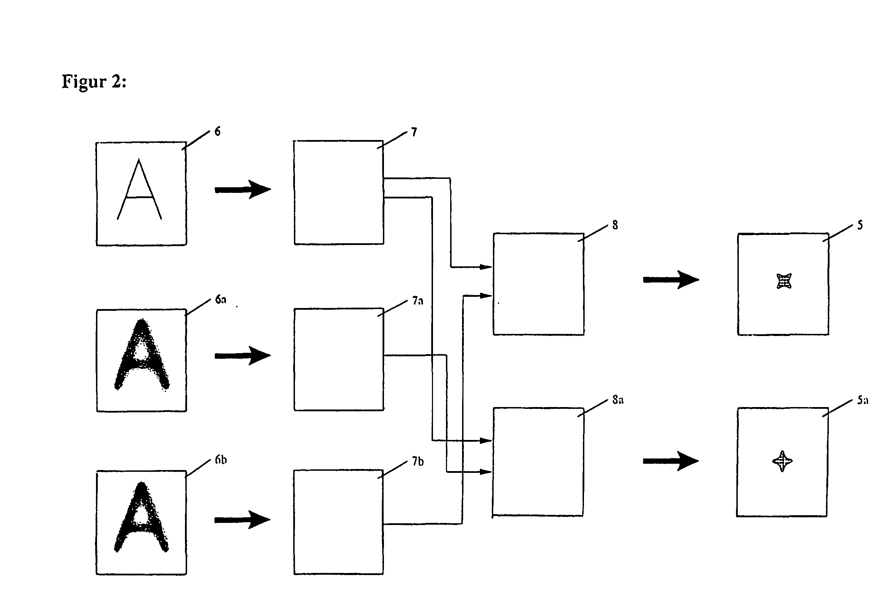

In Figur 2 ist die Vorgehensweise dargestellt, mit der die Sondenformen (5,5a) erhalten werden. Dazu wird das Objekt (3) mit einem fokussierten, einem über- und unterfokussierten Teilchenstrahl abgebildet, und anschließend diese Abbildungen (6,6a,6b) einer Fouriertransformation unterzogen. Nach der Divison (8) der Transformierten (7a) der überfokussierten Abbildung durch die Transformierte (7) der fokussierten Abbildung sowie der Rücktransformation des Quotienten sind die Informationen des abgebildeten Objekts (3), die in den ursprünglichen Abbildungen (6,6a,6b) noch enthalten waren, herausdividiert, und als Ergebnis lediglich die Form der Sonde im Über- bzw. Unterfokus (5,5a) erhalten wird. Ebenso wird mit der Transformierten im Unterfokus (7b) verfahren.

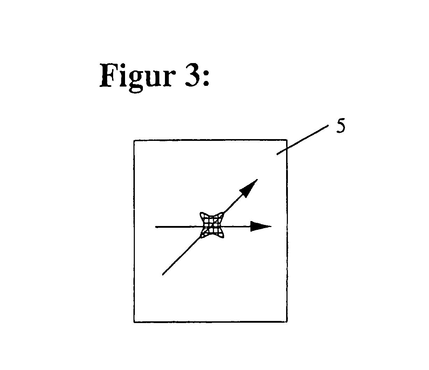

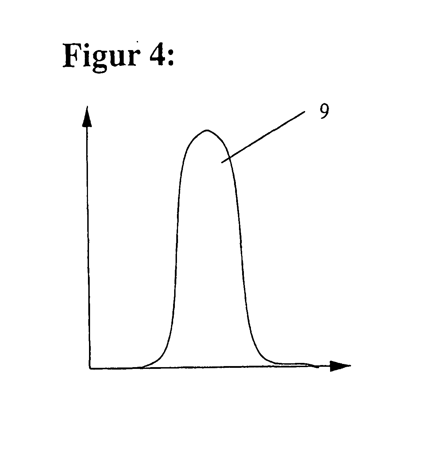

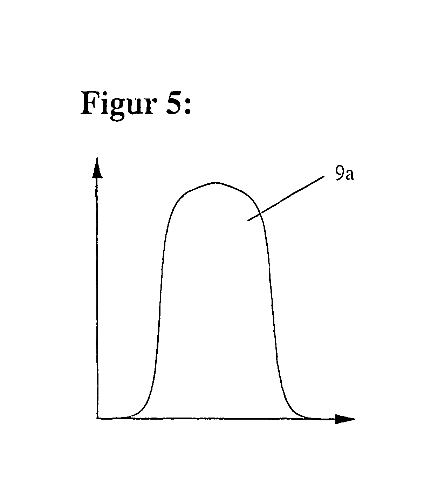

Anschließend werden, wie in Figur 3 dargestellt, Schnitte entlang verschiedener Winkel durch die Sonde (5) gelegt, und aus den unterschiedlichen Formen der Schnitte (9, 9a), wie in den Figuren 4 und 5 dargestellt, insbesondere deren Asymmetrie, Halbwertsbreite oder Krümmung im Schwerpunkt die verschiedenen geometrisch optischen Abbildungsfehler, wie oben beschrieben, ermittelt.

**Patentansprüche**

1. Verfahren zur Ermittlung geometrisch optischer Abbildungsfehler bis einschließlich 3. Ordnung in teilchenoptischen, sondenformenden Anordrningen, insbesondere Rasterelektronenmikroskopen, mit einer im wesentlichen punktförmigen Quelle, die die Teilchen emittiert, Linsen zur Beeinflussung des Teilchenstrahls, einem Objekt, das durch die Teilchen abgebildet wird, und einem Detektor zur Registrierung der Teilchen bzw. der Abbildung des Objekts,
   wobei das Objekt (3) mit einem auf das Objekt (3) fokussierten Teilchenstrahl abgebildet und die Abbildung (6) erfaßt wird,
   der Vorgang mit einem unter- und einem überfokussierten Strahl wiederholt wird, welche die Abbildungen (6a) (überfokussiert) und (6b) (unterfokussiert) ergeben,
   die Abbildungen (6,6a,6b) in den Fourierraum transformiert werden,
   die Transformation der überfokussierten Abbildung (7a) durch die der transformierten fokussierten Abbidlung (7) dividiert und der Quotient (8) erhalten wird, und
   die Transformation der unterfokussierten Abbildung (7b) durch die der transformierten fokussierten Abbildung (7) dividiert und der Quotient (8a) erhalten wird,
   **dadurch gekennzeichnet, daß**

   - beide Quotienten (8, 8a) zurücktransformiert werden und damit die Helligkeitsprofile der Sonden (5,5a), d.h. der Abbildungen der Quelle im Über- und Unterfokus, ermittelt werden,

   - die Asymmetrie (AS) der Profile (9,9a) bezüglich des Schwerpunktes, die Breite (BR) der Profile (9,9a), insbesondere die Halbwertsbreite, und/oder die Krümmung (KR) der Profile (9,9a) im Schwerpunkt bestimmt wird,

   - aus den Unterschieden der Profile (9,9a) der Sonden (5,5a) hinsichtlich dieser Größen die Abbildungsfehler ermittelt werden.

2. Verfahren nach Anspruch 1, **dadurch gekennzeichnet, daß** die Fouriertransformationen bzw. die Rücktransformationen auf mathematischem und/ oder optischem Wege, vorzugsweise durch Erzeugung des Beugungsbildes, erhalten werden.

3. Verfahren nach einem der vorhergehenden Ansprüche, **dadurch gekennzeichnet, daß** der Teilchenstrahl mit elektrischen und/oder magnetischen Multipolen beeinflußt wird.

4. Verfahren nach einem der vorhergehenden Ansprüche, **dadurch gekennzeichnet, daß** die Breite der defokussierten Abbildung (5,5a) der Quelle (1) mindestens zehn mal größer ist als die Breite der fokussierten Abbildung der Quelle (1) bzw. der Quelle (1) selbst.

5. Verfahren nach einem der vorhergehenden Ansprüche, **dadurch gekennzeichnet, daß** durch die Sondenprofile in Über- und Unterfokus in Winkelintervallen, insbesondere alle 15 Grad, Schnitte gelegt werden, und für jeden Schnitt die oben angeführten Größen ermittelt werden.

6. Verfahren nach Anspruch 5, **dadurch gekennzeichnet, daß** zur Ermittlung des Bildfehlers der axialen Koma 2. Ordnung die Mittelwerte der Asymmetrien (AS) der Schnitte durch die Sonden in Über- und Unterfokus in Abhängigkeit von den Schnittwinkeln "w" gebildet und Größe und Orientierung der einzähligen Komponente dieser Mittelwerte, bevorzugt durch Fourieranalyse über den Schnittwinkel "w", bestimmt werden.

7. Verfahren nach Anspruch 5, **dadurch gekennzeichnet, daß** zur Ermittlung des Bildfehlers des dreizähligen Astigmatismus 2. Ordnung die Mittelwerte der Asymmetrien (AS) der Schnitte durch die Sonden in Über- und Unterfokus in Abhängigkeit von den Schnittwinkeln "w" gebildet und Größe und Orientierung der dreizähligen Komponente dieser Mittelwerte, bevorzugt durch Fourieranalyse über den Schnittwinkel "w", bestimmt werden.

8. Verfahren nach Anspruch 5, **dadurch gekennzeich net, daß** zur Ermittlung der Defokussierung die Differenz zwischen den Breiten (BR) der Schnitte durch die Sonden in Über- und Unterfokus in Abhängigkeit von den Schnittwinkel "w" gebildet und die Größe der nullzähligen Komponente dieser Differenzen, vorzugsweise durch Fourieranalyse über den Schnittwinkel "w", bestimmt wird.

9. Verfahren nach Anspruch 5, **dadurch gekennzeichnet, daß** zur Ermittlung des zweizähligen Astigmatismus 1. Ordnung die Differenz zwischen den Breiten (BR) der Schnitte durch die Sonden in Über- und Unterfokus in Abhängigkeit von den Schnittwinkel "w" gebildet und die Größe der zweizähligen Komponente dieser Differenzen, vorzugsweise durch Fourieranalyse über den Schnittwinkel "w", bestimmt wird.

**10.** Verfahren nach Anspruch 5, **dadurch gekennzeichnet, daß** zur Ermittlung des Öffnungsfehlers 3. Ordnung die Differenz zwischen der Krümmung KR der Schnitte durch die Sonden in Über- oder Unterfokus in Abhängigkeit von den Schnittwinkeln "w" gebildet und die Größe der nullzähligen Komponente dieser Differenzen, vorzugsweise durch Fourieranalyse über den Schnittwinkel "w", bestimmt wird.

**11.** Verfahren nach Anspruch 5, **dadurch gekennzeichnet, daß** zur Ermittlung des Sternfehlers 3. Ordnung die Differenz zwischen der Krümmung KR der Schnitte durch die Sonden in Über- oder Unterfokus in Abhängigkeit von den Schnittwinkeln "w" gebildet und die Größe der zweizähligen Komponente dieser Differenzen, vorzugsweise durch Fourieranalyse über den Schnittwinkel "w", bestimmt wird.

**12.** Verfahren nach Anspruch 5, **dadurch gekennzeichnet, daß** zur Ermittlung des vierzähligen Astigmatismus 3. Ordnung die Differenz zwischen der Krümmung KR der Schnitte durch die Sonden in Über- oder Unterfokus in Abhängigkeit von den Schnittwinkeln "w" gebildet und die Größe der vierzähligen Komponente dieser Differenzen, vorzugsweise durch Fourieranalyse über den Schnittwinkel "w", bestimmt wird.

**13.** Verfahren nach Anspruch 10, **dadurch gekennzeichnet, daß** zur Bestimmung des Öffnungsfehlers 3. Ordnung anstatt der Differenz der Krümmung (KR) die Differenz einer Linearkombination von Krümmung (KR) und Breite (BR) in der Form

$$\alpha * BR + \beta * KR$$

verwendet wird, wobei $\alpha$ und $\beta$ empirisch ermittelt werden und den jeweiligen Mittelwert über den Schnittwinkel "w" darstellen.

**Claims**

**1.** Method for determining geometrical-optical aberrations up to and including 3rd order in particle-optical, probe-forming systems, in particular scanning electron microscopes, comprising an essentially punctiform source, which emits the particles, lenses for influencing the particle beam, an object, which is imaged by the particles, and a detector for registering the particles or the image of the object, the object (3) being imaged by means of a particle beam focussed on the object (3), and the image (6) being recorded,
the process being repeated by means of an overfocussed and an overfocussed beam, which produce the images (6a) (overfocussed) and (6b) (underfocussed),
the images (6, 6a, 6b) being transformed in Fourier space,
the transformation of the overfocussed image (7a) being divided by that of the transformed focussed image (7), and the quotient (8) being obtained, and the transformation of the underfocussed image (7b) being divided by that of the transformed focussed image (7) and the quotient (8a) being obtained, **characterised in that**

- both quotients (8, 8a) are reverse transformed and thereby the brightness profiles of the probes (5, 5a), that is to say of the images of the source in overfocus and underfocus, are determined,

- the asymmetry (AS) of the profiles (9, 9a) with respect to the centre, the width (BR) of the profiles (9,9a), in particular the half-value width, and/or the curvature (KR) of the profiles (9, 9a) in the centre are determined,

- the differences of the profiles (9, 9a) of the probes (5, 5a) with respect to these parameters are used to determine the image aberrations.

**2.** Method according to claim 1, **characterised in that** the Fourier transformation and/or the reverse transformation is obtained by mathematical and/or optical means, preferably by generating the diffraction pattern.

**3.** Method according to one of the preceding claims, **characterised in that** the particle beam is influenced with electrical and/or magnetic multipoles.

**4.** Method according to one of the preceding claims, **characterised in that** the width of the defocused image (5, 5a) of the source (1) is at least ten times greater than the width of the focussed image of the source (1) or of the source (1) itself.

**5.** Method according to one of the preceding claims, **characterised in that**, sections are taken at angular intervals, in particular every 15 degrees, through the probe profiles in overfocus and underfocus, and the aforementioned parameters are determined for each section.

**6.** Method according to claim 5, **characterised in that**, for determining the image aberration of the 2nd order axial coma, the mean values of the asymmetries (AS) of the sections through the probes in overfocus and underfocus in dependence on the section angles "w" are formed, and the magnitude and orientation of the one-fold components of these mean values are determined, preferably by Fourier analysis through the section angle "w".

7. Method according to claim 5, **characterised in that**, for determining the image aberration of the three-fold 2nd order astigmatism, the mean values of the asymmetries (AS) of the sections through the probes in overfocus and underfocus in dependence on the section angles "w" are formed, and the magnitude and orientation of the three-fold component of these mean values are determined, preferably by Fourier analysis through the section angle "w".

8. Method according to claim 5, **characterised in that**, for determining the defocussing, the difference between the widths (BR) of the sections through the probes in overfocus and underfocus in dependence on the section angle "w" is formed, and the magnitude of the zero-fold component of these differences are determined preferably by Fourier analysis through the section angle "w".

9. Method according to Claim 5, **characterised in that,** for determining the two-fold 1st order astigmatism, the difference between the widths (BR) of the sections through the probes in overfocus and underfocus in dependence on the section angle "w" is formed, and the magnitude of the two-fold component of these differences is determined, preferably by Fourier analysis through the section angle "w".

10. Method according to claim 5, **characterised in that**, for determining the 3rd order spherical aberration, the difference between the curvature KR of the sections through the probes in overfocus or underfocus is formed in dependence on the section angle "w" and the magnitude of the zero-fold component of these differences is determined, preferably by Fourier analysis through the section angle "w".

11. Method according to claim 5, **characterised in that**, for determining the 3rd order stellar aberration, the difference between the curvature KR of the sections through the probes in overfocus or underfocus is formed in dependence on the section angles "w", and the magnitude of the two-fold component of these differences is determined, preferably by Fourier analysis through the section angle "w".

12. Method according to claim 5, **characterised in that**, for determining the four-fold 3rd order astigmatism, the difference between the curvature KR of the sections through the probes in overfocus or underfocus in dependence on the section angles "w" is formed, and the magnitude of the four-fold component of these difference is determined, preferably by Fourier analysis through the section angle "w".

13. Method according to claim 10, **characterised in that**, for determining the 3rd order spherical aberration, instead of the difference in curvature (KR), the difference of a linear combination of curvature (KR) and width (BR) is used in the form

$$\alpha * BR + \beta * KR$$

$\alpha$ and $\beta$ being determined empirically and representing the respective mean value with respect to the section angle "w".

## Revendications

1. Procédé de détermination d'aberrations opto-géométriques jusqu'à l'ordre 3 compris dans des systèmes optiques à particules formant des sondes, en particulier dans des microscopes électroniques à balayage, avec une source essentiellement ponctuelle qui émet les particules, des lentilles pour agir sur le faisceau de particules, un objet qui est reproduit par les particules, et un détecteur pour enregistrer les particules ou encore l'image de l'objet,
sachant que l'objet (3) est reproduit par un faisceau de particules focalisé sur l'objet (3), et qu'on enregistre l'image (6),
que le processus est répété avec un faisceau sous-focalisé et avec un faisceau surfocalisé,
qui fournissent les images (6a) (surfocalisée) et (6b) (sous-focalisée),
que les images (6, 6a, 6b) sont transformées dans l'espace de Fourier,
que la transformation (7a) de l'image surfocalisée est divisée par celle de l'image focalisée transformée (7), et qu'on obtient le quotient (8),
et que la transformation (7b) de l'image sous-focalisée est divisée par celle de l'image focalisée transformée (7), et qu'on obtient le quotient (8a),
**caractérisé en ce que**

- on effectue la transformation inverse des deux quotients (8, 8a) et on détermine ainsi les profils de luminosité des sondes (5, 5a), c'est-à-dire les images de la source au surfoyer et au sous-foyer,
- on détermine l'asymétrie (AS) des profils (9, 9a) par rapport au centre de gravité, la largeur (BR) des profils (9, 9a), notamment la largeur de valeur moyenne, et/ou la courbure KR des profils (9, 9a) au centre de gravité,
- on détermine les aberrations d'après les différences des profils (9, 9a) des sondes (5, 5a) concernant ces grandeurs.

2.  Procédé selon la revendication 1, **caractérisé en ce que** les transformations de Fourier et/ou les transformations inverses sont obtenues par voie mathématique et/ou par voie optique, de préférence en produisant le diagramme de diffraction.

3.  Procédé selon l'une des revendications précédentes, **caractérisé en ce qu'**on agit sur le faisceau de particules au moyen de multipôles électriques et/ou magnétiques.

4.  Procédé selon l'une des revendications précédentes, **caractérisé en ce que** la largeur de l'image défocalisée (5, 5a) de la source (1) est au moins dix fois supérieure à la largeur de l'image focalisée de la source (1) ou encore à la largeur de la source (1) elle-même.

5.  Procédé selon l'une des revendications précédentes, **caractérisé en ce qu'**on trace des coupes à intervalles angulaires à travers les profils de sonde au surfoyer et au sous-foyer, notamment tous les 15 degrés, et on détermine pour chaque coupe les grandeurs précitées.

6.  Procédé selon la revendication 5, **caractérisé en ce que**, pour déterminer l'aberration due au coma axial d'ordre 2, on forme les valeurs moyennes des asymétries (AS) des coupes à travers les sondes au surfoyer et au sous-foyer en fonction des angles de coupe "w", et on détermine la grandeur et l'orientation de la composante de degré 1 de ces valeurs moyennes, de préférence par analyse de Fourier sur l'angle de coupe "w".

7.  Procédé selon la revendication 5, **caractérisé en ce que**, pour déterminer l'aberration due à l'astigmatisme de degré 3 et d'ordre 2, on forme les valeurs moyennes des asymétries (AS) des coupes à travers les sondes au surfoyer et au sous-foyer en fonction des angles de coupe "w", et on détermine la grandeur et l'orientation de la composante de degré 3 de ces valeurs moyennes, de préférence par analyse de Fourier sur l'angle de coupe "w".

8.  Procédé selon la revendication 5, **caractérisé en ce que**, pour déterminer la défocalisation, on forme les différences entre les largeurs (BR) des coupes à travers les sondes au surfoyer et au sous-foyer en fonction de l'angle de coupe "w", et on détermine la grandeur de la composante de degré 0 de ces différences, de préférence par analyse de Fourier sur l'angle de coupe "w".

9.  Procédé selon la revendication 5, **caractérisé en**

**ce que**, pour déterminer l'astigmatisme de degré 2 et d'ordre 1, on forme la différence entre les largeurs (BR) des coupes à travers les sondes au surfoyer et au sous-foyer en fonction de l'angle de coupe "w", et on détermine la grandeur de la composante de degré 2 de ces différences, de préférence par analyse de Fourier sur l'angle de coupe "w".

10. Procédé selon la revendication 5, **caractérisé en ce que**, pour déterminer l'erreur d'ouverture d'ordre 3, on forme la différence entre la courbure KR des coupes à travers les sondes au surfoyer ou au sous-foyer en fonction des angles de coupe "w", et on détermine la grandeur de la composante de degré 0 de ces différences, de préférence par analyse de Fourier sur l'angle de coupe "w".

11. Procédé selon la revendication 5, **caractérisé en ce que**, pour déterminer l'aberration spatiale d'ordre 3, on forme la différence entre la courbure KR des coupes à travers les sondes au surfoyer ou au sous-foyer en fonction des angles de coupe "w", et on détermine la grandeur de la composante de degré 2 de ces différences, de préférence par analyse de Fourier sur l'angle de coupe "w".

12. Procédé selon la revendication 5, **caractérisé en ce que**, pour déterminer l'astigmatisme de degré 4 et d'ordre 3, on forme la différence entre la courbure KR des coupes à travers les sondes au surfoyer ou au sous-foyer en fonction des angles de coupe "w", et on détermine la grandeur de la composante de degré 4 de ces différences, de préférence par analyse de Fourier sur l'angle de coupe "w".

13. Procédé selon la revendication 10, **caractérisé en ce que**, pour déterminer l'erreur d'ouverture d'ordre 3, on utilise au lieu de la différence de la courbure (KR) la différence d'une combinaison linéaire de la courbure (KR) et de la largeur (BR) sous la forme

$$\alpha * BR + \beta * KR,$$

où $\alpha$ et $\beta$ sont déterminés empiriquement et représentent la valeur moyenne respective sur l'angle de coupe "w".

# Figur 1:

Figur 2:

Figur 3:

Figur 4:

Figur 5: